**Europäisches Patentamt**

**European Patent Office**

**Office européen des brevets**

(19)

(11) Veröffentlichungsnummer : **0 417 132 B1**

(12) # EUROPÄISCHE PATENTSCHRIFT

(45) Veröffentlichungstag der Patentschrift :
26.08.92 Patentblatt 92/35

(51) Int. Cl.$^5$ : **C30B 15/00, C30B 29/30**

(21) Anmeldenummer : **89905643.6**

(22) Anmeldetag : **30.05.89**

(86) Internationale Anmeldenummer :
**PCT/DE89/00341**

(87) Internationale Veröffentlichungsnummer :
**WO 89/12120 14.12.89 Gazette 89/29**

(54) **LITHIUMNIOBAT-EINKRISTALLE MIT KONGRUENTER ZUSAMMENSETZUNG UND VERFAHREN ZU DEREN HERSTELLUNG.**

(30) Priorität : **31.05.88 DE 3818537**

(43) Veröffentlichungstag der Anmeldung :
**20.03.91 Patentblatt 91/12**

(45) Bekanntmachung des Hinweises auf die
Patenterteilung :
**26.08.92 Patentblatt 92/35**

(84) Benannte Vertragsstaaten :
**AT BE CH DE FR GB IT LI NL SE**

(56) Entgegenhaltungen :
**US-A- 3 639 776**
**Patent Abstracts of Japan, vol. 12, No. 143 (
C-492 ) ( 2990 ), 30 April 1988; & JP,A,62260792**
**Review of the Electrical Communication Laboratories, vol. 23, No.5, 6, May-June 1975 K.Su-
gii et al.: " Characterization ofLiNbO3 single
crystals by X-ray topograph ", pages 569-580
see page 570**

(73) Patentinhaber : **SIEMENS
AKTIENGESELLSCHAFT
Wittelsbacherplatz 2
W-8000 München 2 (DE)**

(72) Erfinder : **BORN, Eberhard
Zittauer Str. 32a
W-8000 München 50 (DE)**
Erfinder : **GRABMAIER, Christa
Am Seefeld 17
W-8131 Berg 1 (DE)**
Erfinder : **HOFMANN, Klaus
Hirtenstrasse 16
W-8000 München (DE)**
Erfinder : **WILLIBALD-RIHA, Evelyn
Lerchenauer Str. 19
W-8000 München 40 (DE)**

EP 0 417 132 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die vorliegende Erfindung bezieht sich auf kongruente Lithiumniobat-Einkristalle nach dem Oberbegriff des Patentanspruchs 1.

Für Oberflächenwellenanordnungen, zum Beispiel für Oberflächenwellenfilter, werden als Substratplättchen Einkristalle verwendet, und zwar insbesondere auch solche aus Lithiumniobat. Einzelheiten über Oberflächenwellenanordnungen und die Verwendung von Lithiumniobat-Einkristallen gehen z.B. aus der anliegenden Druckschrift "Non-Destructive Optical Determination Of Stoichimetry With Its Influence On SAW Propagation Velocity Of LiNbO$_3$", IEEE US-Symp. Proc. (1984) pp. 268 bis 270 und dort angegebenen weiteren Literaturstellen hervor. Über die physikalischen Eigenschaften von Lithiumniobat gibt insbesondere die Veröffentlichung von H. Räuber: "Chemistry and Physics of Lithiumniobat" Current topics of Materials Science", Bd. 1, 1978 p. 481, Auskunft.

Für derartige Oberflächenanordnungen werden Einkristall-Plättchen benötigt, die man aus Kristall-Waferscheiben heraussägt. Solche Waferscheiben haben z.B. 3 bis 5 Zoll Durchmesser und eine Dicke von ca. 0,3 bis 1 mm, Diese Waferscheiben gewinnt man aus bulk-crystals, die mit einem Züchtungsverfahren nach Czochralski hergestellt werden. Das Czochralski-Verfahren besteht darin, daß man eine Schmelze der Bestandteile des herzustellenden bulk-crystals in einem Tiegel erzeugt. Diese Schmelze wird in dem Tiegel auf möglichst exakt der Schmelztemperatur gehalten. Man taucht von oben her einen Keimkristall derart in die Schmelze ein, daß dieser Keimkristall die Oberfläche der Schmelze berührt. Als Keimkristall verwendet man einen z.B. durch Sägen hergestellten Einkristall mit vorgegebener Kristall-Orientierung. An der in die Schmelze eintauchenden Fläche des Keimkristalls wächst bei geringfügigem Unterschreiten der Schmelztemperatur Material der Schmelze einkristallin an dem Keimkristall an. Oer Keimkristall wird langsam aus der Schmelze hochgezogen, und zwar derart, daß laufend einkristallinanwachsendes Material der Scmelze den wachsenden Kristall fortlaufend derart verlängert, daß die Berührung mit der Oberfläche der Schmelze aufrecht erhalten bleibt.

Für Oberflächenwellenanordnungen werden Lithiumniobat-Einkristalle benötigt, die als Substrat-Plättchen eine ganz bestimmte Kristallorientierung der Normalen in der Oberfläche des Substratplättchens haben. D.h., daß die Fortpflanzungsrichtung der in der Oberfläche der Oberflächenwellenanordnung (zwischen auf der Oberfläche des Substratplättchens befindlichen Elektroden- und/oder Reflektorstrukturen) verlaufenden Oberflächenwellen mit dieser vorgegebenen Kristallorientierung parallel ist.

Damit die für die jeweiligen Oberflächenwellenanordnungen zu verwendenden Substratplättchen diese vorgegebene Orientierung haben, ist es erforderlich, daß auch die Waferscheiben, aus denen die Substratplättchen schließlich herausgetrennt werden, dieselbe Orientierung haben. Damit ergibt sich das praktische Erfordernis, daß auch der jeweils nach dem Czochralski-Verfahren gezogene bulk-crystal als Ziehrichtung diese Orientierung hat. Da aus einem solchen bulk-crystal eine große Anzahl Waferscheiben hergestellt werden ist es erforderlich, daß ein jeweiliger bulk-crystal praktisch überall genau ein und dieselbe Zusammensetzung hat. Würde dies nämlich nicht der Fall sein, würden Waferscheiben unterschiedliche Zusammensetzung und damit unterschiedliche physikalische Eigenschaften haben, je nachdem an welcher Stelle des bulk-crystals eine jeweilige Waferscheibe herausgesägt worden ist. Entsprechende Unterschiede würden dann auch die einzelnen Substratplättchen bzw. die aus ihnen hergestellten Oberflächenwellenanordnungen haben. In diesem Zusammenhang ist darauf hinzuweisen, daß Oberflächenwellenanordnungen außerordentlich große Abhängigkeit von den physikalischen Eigenschaften des Materials der Substratplättchen haben. Es ist also sehr wichtig, bulk-crystals (aus im vorliegenden Falle Lithiumniobat) herzustellen, die bei vorgegebener Kristallorientierung über die ganze Länge sehr genau dieselbe Zusammensetzung haben. Man erreicht dies bei kongruenter Zusammensetzung der Schmelze.

Es ist eine Aufgabe der vorliegenden Erfindung, für Lithiumniobat die kongruente Zusammensetzung für die hier vorgegebene Kristallorientierung rot-y und die dazugehörige Zusammensetzung der Schmelze anzugeben, aus der ein jeweiliger bulk-crystal zu ziehen ist.

Diese Aufgabe wird mit der Lehre nach dem Patentanspruch 1.

Es ist bekannt gewesen, daß ein Lithiumniobat-Kristall mit kongruenter Zusammensetzung, d.h. ein kongruenter bulk-crystal, nicht exakt die stöchiometrische Zusammensetzung mit 50 mol % Li und 50 mol % NbO$_3$ hat. Vielmehr ist die kongruente Zusammensetzung mit 48,45 mol % und entsprechend 51,55 mol % NbO$_3$ angegeben worden.

Die Erfinder haben festgestellt, daß für Lithiumniobat nicht nur eine einzige kongruente Zusammensetzung gilt, sondern daß die kongruente Zusammensetzung für verschiedene Kristallorientierungen als Wachstumsrichtung im Czochralski-Verfahren unterschiedlich sind. Die Unterschiede sind zwar hinsichtlich der mol-Prozente sehr gering. Solche geringen Unterschiede machen sich aber für Oberflächenwellenanordnungen außerordentlich (nachteilig) bemerkbar, so daß das Erfordernis festgestellt wurde, sehr genau die kongruente Zusammensetzung in Abhängigkeit von der Kristallrichtung der Kristallzüchtung zu kennen und einzuhalten.

2

Es wurde gefunden, daß für die Einkristalle der Kristallrichtung rot-y mit 127,86° gegenüber der Z-Richtung des Kristalls die kongruente Zusammensetzung bei 48,25 ± 0,1 mol % für Li liegt. Das bedeutet, daß für die Herstellung der Lithiumniobat-Einkristalle mit dieser Orientierung eine Schmelze zu verwenden ist, die diese voranstehend angegebene Zusammensetzung Li: $48,25 \pm 0,1$ mol % und $NbO_3 = 51,75 \mp 0,1$ mol % (insgesamt 100 %) aufweist.

Ein aus einer derartigen Schmelze nach Czochralski mit der Richtung rot-y gezogener einkristalliner bulk-crystal hat kongruente Zusammensetzung, d.h. vom Anfang bis zum Ende der Züchtung des bulk-crystals hat dieser Kristall kongruente, einheitliche Zusammensetzung. Für aus einem solchen bulk-Kristall hergestellte Waferscheiben ist es hinsichtlich der für Oberflächenwellenanordnungen maßgeblichen physikalischen Größen in der Praxis unwesentlich, ob die später zu Substratplättchen verarbeiteten Waferscheiben aus einem Anteil des bulk-crystals stammt, der zu Anbeginn oder der in der Mitte oder der zum Ende des Ziehens des bulk-crystals nach Czochralski entstanden ist.

Mit der Erfindung konnte ein wesentlicher Fortschritt dahingehend erzielt werden, das kostspielige Kristallmaterial in optimaler Weise, d.h. möglichst verlustlos, für hochwertige Oberflächenwellenanordnungen auszunutzen.

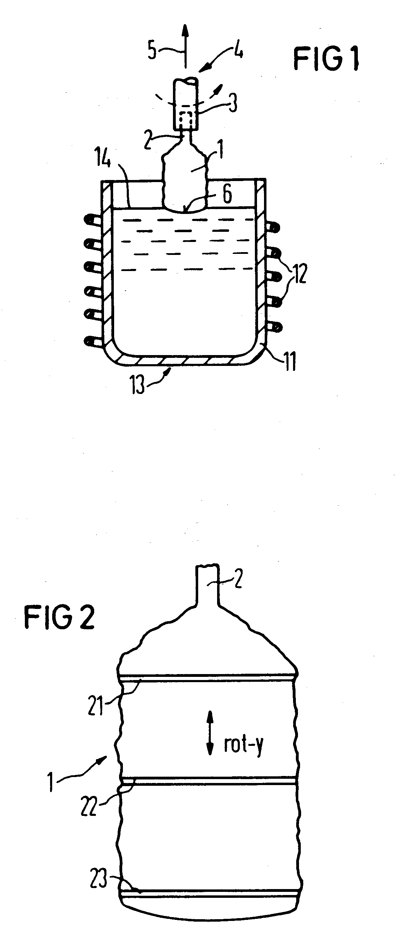

Fig. 1 zeigt eine Anordnung zum Züchten bzw. Ziehen eines bulk-crystals 1. Mit 2 ist der Keimkristall bezeichnet. Dieser ist in eine Halterung 3 eingespannt, die ein Teil der nicht näher dargestellten Ziehvorrichtung 4 ist. Zum Beispiel führt diese Ziehvorrichtung 4 außer der axialen Bewegung 5 noch eine Rotationsbewegung aus.

Mit 11 ist ein Tiegel aus Platin und mit 12 ist eine elektrische Heizung für diesen Tiegel bezeichnet. In dem Tiegel befindet sich die Schmelze 13, die die anspruchsgemäße kongruente Zusammensetzung hat. Als Ausgangsstoffe werden insbesondere Lithiumcarbonat und Niobpentoxid verwendet, die in dem Tiegel zum Schmelzen gebracht werden. Mit 14 ist die Oberfläche der Schmelze bezeichnet, die der bulk-crystal mit seinem Meniskus 6 berührt. An diesem Meniskus 6 wächst bei langsamem Ziehen in Richtung 5 fortlaufend weiteres Kristallmaterial aus der Schmelze einkristallin an. Die Ziehgeschwindigkeit beträgt z.B. 2 mm pro Stunde.

Fig. 2 zeigt eine nach Czochralski und nach Fig. 1 gezogenen bulk-crystal 1. Fig. 2 zeigt drei Waferscheiben 21, 22 und 23. In derartige Waferscheiben wird der bulk-crystal im Bereich zwischen den Waferscheiben 21 und 23 orthogonal zur Zielrichtung 5 zerschnitten. Die Normale der Waferscheiben 21 bis 23 stimmt überein mit der Ziehrichtung rot-y des bulk-crytals 1. Diese Richtung hat 127,86° gegenüber der Z-Richtung. Bei entsprechend der Erfindung gewählter Schmelze haben sowohl die Scheibe 21 als auch die Scheibe 23 und die Scheibe 22 (und alle dazwischen liegenden Scheiben) ein und dieselbe anspruchsgemäße, kongruente Zusammensetzung.

Einkristall-Scheiben, -Plättchen, -Platten und dergleichen nach der Erfindung sind auch für elektro-optische und/oder nichtlinear-optische Elemente begehrt. Auch bei diesen Elementen kommt es auf sehr genaue Einhaltung der optischen Werte, insbesondere des Brechungsindices an. Derartige elektrooptische Elemente sind z.B. elektrisch steuerbare Doppelbrechungselemente, Richtkopplungshalter, optische Kreuzschalter, Mach-Zehnder-Modulatoren und dergleichen. Nichtlinear optische Elemente werden z.B. wie Frequenzverdopplung optischer Strahlung verwendet.

## Patentansprüche

1. Lithiumniobat-Einkristall mit der Kristall-Orientierung rot-y mit 127,86° gegenüber der Z-Richtung des Kristalls,
   **gekennzeichnet** durch
   die Zusammensetzung
   Li      : $48,25 \pm 0,1$ mol % und
   $NbO_3$  : $51,75 \mp 0,1$ mol %
   mit insgesamt 100 %
   als kongruenter Einkristall (1).

2. Verwendung eines Einkristalls nach Anspruch 1 als bulk-crystal (1) für Waferscheiben (21 bis 23) für Substratplättchen für Oberflächenwellen-Anordnungen.

3. Verwendung eines Einkristalls nach Anspruch 1 als elektro-optisches Element.

4. Verwendung eines Einkristalls nach Anspruch 3 als Substrat für Lichtwellenleiter.

5. Verwendung eines Einkristalls nach Anspruch 1 als nicht-lineares optisches Element.

6. Verfahren zur Herstellung eines Einkristalls nach Anspruch 1 durch Ziehen nach Czochralski aus einer kongruenten Schmelze mit
   Li : 48,25 ± 0,1 mol % und
   NbO$_3$ : 51,75 ∓ 0,1 mol %
   mit insgesamt 100 %.

## Claims

1. Lithium niobate single crystal having the crystal orientation rot-y at 127.86° relative to the Z-direction of the crystal, characterised by the composition
   Li : 48.25 ± 0.1 mol % and
   NbO$_3$ : 51.75 ± 0.1 mol %,
   giving a total of 100%,
   as congruent single crystal (1).

2. Use of a single crystal according to Claim 1 as a bulk crystal (1) for wafer discs (21 to 23) for substrate laminae of surface wave arrangements.

3. Use of a single crystal according to Claim 1 as an electro-optical element.

4. Use of a single crystal according to Claim 3 as a substrate for optical waveguides.

5. Use of a single crystal according to Claim 1 as a non-linear optical element.

6. Method for producing a single crystal according to Claim 1 by drawing in conformity with Czochralski from a congruent melt having
   Li : 48.25 ± 0.1 mol % and
   NbO$_3$ : 51.75 ± 0.1 mol %,
   giving a total of 100%.

## Revendications

1. Monocristal de niobate de lithium d'orientation cristalline rot-y á 127,86° par rapport à la direction Z du cristal, caractérisé par la composition
   Li : 48,25 ± 0,1 % en mole et
   NbO$_3$ : 51,75 ± 0,1 % en mole
   le tout représentant 100 %
   sous la forme d'un monocristal (1) congruent.

2. Utilisation d'un monocristal suivant la revendication 1, comme bulk-crystal (1) de pastilles (21 à 23) pour des plaquettes de substrat de dispositifs à ondes de surface.

3. Utilisation d'un monocristal suivant la revendication 1, comme élément optoélectronique.

4. Utilisation d'un monocristal suivant la revendication 3, comme substrat pour une fibre optique.

5. Utilisation d'un monocristal suivant la revendication 1, comme élément optique non linéaire.

6. Procédé de préparation d'un monocristal suivant la revendication 1 par tirage, suivant la technique de Czochralski, à partir d'une masse fondue congruente, comprenant
   Li : 48,25 ± 0,1 % en mole et
   NbO$_3$ : 51,75 ± 0,1 % en mole
   le tout représentant 100 %.

FIG 1

FIG 2

rot-y